Europäisches Patentamt

European Patent Office

Office européen des brevets

(19)

(11) Numéro de publication : **0 093 633**
**B1**

(12) **FASCICULE DE BREVET EUROPÉEN**

(45) Date de publication du fascicule du brevet :
28.05.86

(51) Int. Cl.⁴ : **H 01 L 23/14, H 01 L 21/48**

(21) Numéro de dépôt : **83400752.8**

(22) Date de dépôt : **15.04.83**

(54) **Substrat pour circuit électronique, et procédé de fabrication de ce substrat.**

(30) Priorité : **16.04.82 FR 8206599**

(43) Date de publication de la demande :
**09.11.83 Bulletin 83/45**

(45) Mention de la délivrance du brevet :
**28.05.86 Bulletin 86/22**

(84) Etats contractants désignés :
**DE GB IT NL SE**

(56) Documents cités :
**GB-A- 1 474 902**
**US-A- 4 067 041**
**IBM TECHNICAL DISCLOSURE BULLETIN; vol. 21,
no. 5, octobre 1978, pages 1895-1897, New York, USA
S. MAGDO: "Low inductance module"**

(73) Titulaire : **THOMSON-CSF**
**173, Boulevard Haussmann**
**F-75379 Paris Cedex 08 (FR)**

(72) Inventeur : **Resneau, Jean-Claude**
**THOMSON-CSF SCPI 173, bld Haussmann**
**F-75379 Paris Cedex 08 (FR)**
Inventeur : **Roset, Pierre**
**THOMSON-CSF SCPI 173, bld Haussmann**
**F-75379 Paris Cedex (FR)**
Inventeur : **Doyen, Jean**
**THOMSON-CSF SCPI 173, bld Haussmann**
**F-75379 Paris Cedex 08 (FR)**

(74) Mandataire : **Benoit, Monique et al**
**THOMSON-CSF SCPI 19, avenue de Messine**
**F-75008 Paris (FR)**

## Description

L'invention concerne un substrat destiné aux circuits électroniques fonctionnant notamment dans les hyperfréquences. Elle concerne également le procédé de fabrication de ce substrat.

Il est connu de réaliser de tels substrats en quartz, mais celui-ci présente cependant deux types de défauts :

le quartz ne permet de réaliser que des substrats de petites dimensions ;

les caractéristiques thermiques du quartz le rendent fragile aux chocs thermiques, et il a l'inconvénient d'avoir un coefficient de dilatation linéaire très faible par rapport aux autres matériaux utilisés dans ce domaine, ce qui rend son utilisation très délicate et même impossible dans certains cas. De plus sa conductibilité thermique est très mauvaise, en comparaison de celle de l'oxyde de béryllium ou de l'alumine par exemple.

Il est connu par ailleurs d'utiliser du nitrure de bore pour la réalisation des substrats de circuits électroniques fonctionnant jusqu'à la bande X c'est-à-dire 12 GHz, et même au-delà, car c'est un isolant, il a une constante diélectrique ε faible et une tangente de l'angle de perte tg δ faible. Le nitrure de bore est intéressant car :

on sait en fritter des plaques de grandes dimensions, ce qui permet de réaliser des substrats ayant, à titre d'exemple, 300 × 125 mm de côté, ce qui est inconcevable avec le quartz ;

ses caractéristiques diélectriques permettent de réaliser des lignes d'impédance élevée ou d'obtenir des pertes entre conducteurs plus faibles pour une impédance donnée ;

ses caractéristiques thermiques sont comparables à celles des matériaux en conjugaison desquels il est utilisé.

Cependant, le nitrure de bore n'est pas métallisable par des moyens classiques, tels que les dépôts en couche épaisse (argent, argent palladium, or platine...), ou en couches minces, déposées sous vide ou par un procédé chimique. En effet le nitrure de bore est trop mou en surface et trop friable. La cohésion des grains en surface d'une plaque de nitrure de bore n'est pas suffisante, et est comparable à celle d'une surface de plâtre par exemple.

L'utilisation du nitrure de bore comme substrat métallisé est rendue possible grâce à l'invention, qui prévoit de donner au nitrure de bore une surface dure et non friable en déposant du verre, sous une faible épaisseur, qui assure la cohésion des grains sans détériorer les caractéristiques électriques et thermiques du nitrure de bore. La surface recouverte de verre est alors métallisable par des moyens classiques.

De façon plus précise, l'invention concerne un substrat pour circuit électronique, comportant un premier matériau, à base de nitrure de bore, et un second matériau, à base de verre, déposé en une couche d'épaisseur faible par rapport à celle du premier matériau, sur une face au moins du premier matériau et permettant une bonne cohésion des grains de nitrure de bore en surface.

L'invention sera mieux comprise par la description qui suit d'un exemple de réalisation de substrats pour circuits hyperfréquences.

Parmi les différents types de nitrure de bore, puisque ce produit, comme les céramiques, n'a pas une composition fixe, celui qui correspond à une composition comprenant environ 42 % de bore, 53,5 % d'azote, et parmi différentes impuretés de 1,5 à 2,5 % d'oxygène et 1,5 % de calcium, a les caractéristiques suivantes lorsqu'il est fritté en plaque :

constante diélectrique ε = 4,11

facteur de pertes tg δ = $10^{-3}$ à 1 MHz

coefficient de dilatation linéaire $7 \cdot 10^{-6}$, dans le sens parallèle, c'est-à-dire dans le sens des grandes dimensions d'un substrat, par opposition au sens perpendiculaire qui correspond à l'épaisseur du substrat

conductibilité thermique = 0,15 cal/cm²/sec/°C/cm.

Ce nitrure de bore est intéressant pour réaliser des substrats bien que sa constante diélectrique 4,11 soit légèrement supérieure à celle du quartz, qui est égale à 3,7. Mais, comme cela a été dit, il est trop mou et trop friable en surface pour qu'une métallisation adhère parfaitement.

Les caractéristiques thermiques et diélectriques d'un tel matériau ne sont pas altérées, mais au contraire sa surface est rendue dure et non friable par le dépôt d'une couche de verre que l'on choisit, selon les applications, parmi ceux qui ont des caractéristiques électriques voisines de celles du nitrure de bore, ou de constante diélectrique inférieure, par exemple voisine de celle du quartz.

Le verre choisi est d'autant plus proche de la silice pure $SiO_2$ que les caractéristiques requises pour le fonctionnement en hyperfréquences sont plus sévères. Un verre pratiquement pur, c'est-à-dire $SiO_2$, de très bonne qualité hyperfréquence a une température de fusion voisine de 1 300°. Selon la destination du substrat, ou selon la fréquence de travail, il est possible d'utiliser également un verre légèrement dopé, dont la température de fusion est de l'ordre de 700°.

Le verre choisi peut être déposé en couches de l'ordre de 10 à 15 microns seulement d'épaisseur par sérigraphie d'une pâte classique comprenant de la poudre de verre et des liants, agents organiques, cette couche étant ensuite cuite en four à une température au moins égale à la température de fusion du verre, température à laquelle tous les solvants organiques sont évaporés. Le verre peut également être déposé par pulvérisation cathodique radiofréquence, sous vide, selon la technologie dite des couches minces ou encore par un dépôt chimique en phase vapeur à basses pressions selon la technologie dite CVD, abréviation dont l'origine est dans l'expression anglaise « chemical vapor deposition ».

Le verre choisi pour réaliser soit une couche mince soit une couche plus épaisse de l'ordre de 10 à 15 microns permet une bonne cohésion des grains de nitrure de bore en surface ; il s'agit d'une vitrification de surface. Il est métallisable notamment selon la technique des couches minces. Sous une très faible épaisseur, il ne pénalise pas de manière sensible le dispositif fonctionnel sur le plan de la résistance thermique. En outre, il peut être choisi pour que son coefficient de dilatation linéaire soit très voisin de celui du nitrure de bore, ce qui évite par la suite en cours de fonctionnement des arrachements ou délaminations entre la couche de nitrure de bore et la couche de verre. Quant à ses caractéristiques diélectriques, ε et tg δ, il est possible de les adapter à celles du nitrure de bore, comme pour les caractéristiques thermiques, selon la nature des éléments de dopage ajoutés au verre, ce qui fait qu'il n'y a pas de discontinuité diélectrique dans le substrat de nitrure de bore ainsi perfectionné par l'adjonction d'une couche de verre en surface.

L'invention a été décrite en s'appuyant sur l'exemple non limitatif d'un substrat de grandes dimensions, dimensions que ne peut atteindre un substrat de quartz. Cependant l'invention garde toute sa valeur si elle est appliquée à un substrat de dimensions plus réduites, allant jusqu'à ce qu'il est convenu d'appeler un pavé isolant, de la taille d'environ une pastille de semiconducteur, ce pavé étant situé et soudé entre la pastille semiconductrice hyperfréquence et un boîtier d'encapsulation. Le fait de pouvoir métalliser un tel substrat permet soit de déposer des métallisations pour soudures de pastilles semiconductrices, soit : de déposer des bandes conductrices sur ce substrat, afin de réaliser des circuits fonctionnant en hyperfréquences selon la technologie de bandes, dite « strip-line » en anglais.

## Revendications

1. Substrat pour circuit électronique, comprenant un premier matériau, à base de nitrure de bore, et un second matériau, à base de verre, déposé en une couche d'épaisseur faible par rapport à celle du premier matériau, sur une face au moins du premier matériau et permettant une bonne cohésion des grains de nitrure de bore en surface.

2. Substrat selon la revendication 1, caractérisé par le fait qu'il comporte en outre une métallisation de la face libre du second matériau.

3. Substrat selon l'une des revendications précédentes, caractérisé par le fait que le premier matériau comporte sensiblement : 42 % de bore ; 53,5 % d'azote ; entre 1,5 et 2,5 % d'oxygène, et 1,5 % de calcium.

4. Substrat selon l'une des revendications précédentes, caractérisé par le fait que le second matériau comporte de la silice dopée.

5. Substrat selon l'une des revendications précédentes, caractérisé par le fait que le second matériau a des caractéristiques thermiques voisines de celles du premier matériau.

6. Substrat selon l'une des revendications précédentes, caractérisé par le fait que le second matériau a des caractéristiques électriques voisines de celles du premier matériau.

7. Substrat selon l'une des revendications 1 à 5, caractérisé par le fait que le second matériau a une constante diélectrique inférieure à celle du premier matériau.

8. Procédé de fabrication d'un substrat selon l'une des revendications précédentes, caractérisé par le fait qu'il comporte une étape de dépôt du second matériau par sérigraphie, par pulvérisation cathodique ou par dépôt chimique en phase vapeur.

9. Procédé selon la revendication 8, caractérisé par le fait qu'il comporte en outre une étape de métallisation du second matériau.

## Claims

1. Substrate for an electronic circuit comprising a first boron nitride based material and a second glass based material deposited as a layer of low thickness compared to that of the first material on at least one face of the first material and permitting a good surface cohesion of the boron nitride grains.

2. Substrate according to claim 1, characterized by the fact that it further comprises a metallization of the free face of the second material.

3. Substrate according to any of the preceding claims, characterized by the fact that the first material comprises substantially : 42 % of boron ; 53.5 % of nitrogen ; between 1.5 and 2.5 % of oxygen and 1.5 % of calcium.

4. Substrate according to any of the preceding claims, characterized by the fact that the second material comprises doped silica.

5. Substrate according to any of the preceding claims, characterized by the fact that the second material has thermal characteristics close to those of the first material.

6. Substrate according to any of the preceding claims, characterized by the fact that the second material has electric characteristics close to those of the first material.

7. Substrate according to any of claims 1 to 5, characterized by the fact that the second material has a dielectric constant smaller than that of the first material.

8. Method of producing a substrate according to any of the preceding claims, characterized by the fact that it comprises a step of deposition of the second material by serigraphy, by cathode sputtering or by chemical deposition from the vapor phase.

9. Method according to claim 8, characterized by the fact that it further comprises a step of metallization of the second material.

## Patentansprüche

1. Substrat für eine Elektronikschaltung, mit einem ersten Basismaterial aus Bornitrid und einem zweiten Material auf Glasbasis, welches als Schicht von geringer Dikke im Vergleich zu der des ersten Materials auf wenigstens einer Fläche des ersten Materials aufgebracht ist und eine gute Haftung der Bornitridkörner an der Oberfläche gestattet.

2. Substrat nach Anspruch 1, dadurch gekennzeichnet, daß es ferner eine Metallisierung der freien Fläche des zweiten Materials umfaßt.

3. Material nach einem der vorstehenden Ansprüche, dadurch gekennzeichnet, daß das erste Material etwa enthält : 42 % Bor ; 53,5 % Stickstoff ; zwischen 1,5 und 2,5 % Sauerstoff und 1,5 % Kalzium.

4. Substrat nach einem der vorstehenden Ansprüche, dadurch gekennzeichnet, daß das zweite material dotiertes Siliciumoxid enthält.

5. Substrat nach einem der vorstehenden Ansprüche, dadurch gekennzeichnet, daß das zweite Material thermische Eigenschaften aufweist, die nahe bei denen des ersten materials liegen.

6. Substrat nach einem der vorstehenden Ansprüche, dadurch gekennzeichnet, daß das zweite Material elektrische Eigenschaften aufweist, die nahe bei denen des ersten Materials liegen.

7. Substrat nach einem der Ansprüche 1 bis 5, dadurch gekennzeichnet, daß das zweite Material eine Dielektrizitätskonstante aufweist, die kleiner als die des ersten Materials ist.

8. Verfahren zur Herstellung eines Substrats nach einem der vorstehenden Ansprüche, dadurch gekennzeichnet, daß es einen Arbeitsschritt des Ablagerns des zweiten Materials durch Siebdruck, durch Kathodenzerstäubung oder durch chemischen Niederschlag aus der Dampfphase umfaßt.

9. Verfahren nach Anspruch 8, dadurch gekennzeichnet, daß es ferner einen Arbeitsschritt der Metallisierung des zweiten Materials umfaßt.